# EUROPEAN PATENT APPLICATION

(11) **EP 2 098 477 A1**
(43) Date of publication of application: **09.09.2009**
(21) Application number: 08152459.7
(22) Date of filing: 07.03.2008
(51) Int. Cl.: B81B 5/00

(54) **Process for adjusting the friction coefficient between surfaces of two solid objects**

(71) Applicant: Nederlandse Centrale Organisatie Voor Toegepast Natuurwetenschappelijk Onderzoek TNO, 2628 VK Delft (NL)
(72) Inventor: Hermse, Crétien Guillaume Maria, 5664 PS Geldrop (NL); Dillingh, Ebert Christiaan, 2642 DR Pijnacker (NL); Huis in't Veld, Albertus Josef, 5581 JG Waalrre (NL)
(74) Representative: Hatzmann, Martin

(57) **Abstract**

The invention provides a process for adjusting the friction coefficient between a surface of a first solid object and a surface of a second solid object which surfaces are at least partly connected by means of a liquid material, wherein the shear behaviour of the liquid material is adjusted by subjecting at least part of the liquid material to an external stimulus.

## Description

The present invention relates to a process for adjusting the friction coefficient between a surface of a first solid object and a surface of a second solid object which surfaces are at least partly connected by means of a liquid material.

It is well appreciated that in the application of micro electro mechanical systems (MEMS), the moving parts can become stuck to the static parts. This is due to the fact that the static and moving parts (e.g. a miniature silicon rotor in a silicon housing) are very small, flat and close to each other. Surface effects therefore play a large role, and sticking can occur. As a result of the sticking, the MEMS can become non-functional (i.e., the moving parts can not move anymore), or an external force has to be applied to release the moving part, with the substantial risk of damaging the MEMS.

Object of the present invention is to provide a process that improves the reliability of the operation of MEMS and that attractively deals with the above-mentioned problem.

Surprisingly, it has now been found that this can be established when the friction coefficient between the surfaces is adjusted by means of a change in the shear behaviour of the liquid material by subjecting at least part of the liquid material to an external stimulus.

Accordingly, the present invention relates to a process for adjusting the friction coefficient between a surface of a first solid object and a surface of a second solid object which surfaces are at least partly connected by means of a liquid material, wherein the shear behaviour of the liquid material is adjusted by subjecting at least part of the liquid material to an external stimulus.

In accordance with the present invention the surface of a silicon rotor and a silicon housing in a MEMS device can very easily be separated from each other after use, thus avoiding that the surfaces will be damaged and ensuring an attractive reproducibility of the micro system over a longer period of time.

The external stimulus to be used according to the present invention suitably establishes a change in the concentration, the agglomeration, the conglomeration or the stacking of particles that are present in the liquid material, or said stimulus establishes a phase transition in the liquid material.

Preferably, the liquid material to be used in accordance with the present invention is a colloid or a suspension.

More preferably, the liquid material is a colloid.

Suitably, the particles present in the liquid material are charged or magnetic particles.

Suitable examples of charged particles include clay particles and pigment particles. Preferably, the charged particles are clay particles.-

Preferably, the clay particles are kaolinite, smectite, illite or chlorite particles.

Preferably, the pigment particles are titanium oxide or zinc oxide particles.

Suitable examples of magnetic particles include iron particles, magnetite particles, samarium-cobalt particles, cobalt particles, aluminum-nickel-cobalt, titanium-cobalt-nickel-aluminum particles, and neodinium-iron-boron particles.

Preferably, the magnetic particles are iron particles or magnetite particles. More preferably, the magnetic particles are iron particles.

The magnetic particles may suitably comprise a magnetic phase and a non-magnetic phase. Suitable examples of such particles include core-shell particles. Such magnetic particles have the advantage that the shape, surface charge and mechanical properties of the particle can be tuned independently from the magnetic properties.

When in accordance with the present invention the liquid material is a colloid, the liquid phase of the colloid comprises water, a mineral oil, a vegetable oil or an organic solvent.

Suitable examples of mineral oils include petroleums, paraffins, and lubricating oils.

Suitable examples of vegetable oils include rape seed oils, olive oils, linseed oils, sunflower oils, palm oils and sesame oils.

Suitable examples of organic solvents include ethers, alcohols such ethanol and isopropanol, hexane, toluene, acetone, and oleic acid.

Preferably, the organic solvent is an alcohol or an ether.

Suitably, the liquid material to be used in accordance with the present invention comprises liquid crystals.

Suitable examples of such liquid crystals include cholesterol derivates, cholesteryl benzoate, p-methoxybenzylidene-p'-n-butylaniline, cyanobiphenyls, 4-cyano-4-n-pentylbiphenyl (5CB), 4-(1-methylheptyloxycarbonyl)phenyl-4-octyloxybiphenyl-4-carboxylate (MHPOBC), dipalmitoylphospatidylcholine (DPPC), sodium dodecyl sulfate (SDS) and 4-n-methoxybenzylidene-4-n-butylaniline (MBBA). Preferably, the liquid crystals comprise MBBA.

The use of such liquid crystals has the advantage that the gap between the two surfaces can be made smaller than for particles.

The external stimulus to be used in accordance with the present invention is suitably heat, pressure, electro-magnetic radiation, a magnetic field, an electric field, an addition of an acid or a base, or the addition of a salt.

Preferably, the external stimulus is heat or a magnetic field.

When heat is used as the external stimulus suitably use is made of electrical current or radiative effects.

Preferably, the heat is applied by means of electrical current

The temperature to be applied when heat is used can suitably be in the range of from 0-150 °C, preferably in the range of from 20-100°C.

Suitable examples of electro-magnetic radiation include UV (ultraviolet), IR (infra-red), visible light, X-ray radiation.

Preferably, the electro-magnetic radiation is IR or UV. More preferably, the electro-magnetic radiation is IR.

When a magnetic field is used, the magnetic field strength can suitably be in the range of from 0-5 Tesla. Preferably, the magnetic field strength is in the range of from 0-1.5 Tesla.

When an electric field is used, the electric field strength can suitably be in the range of from 0-3000,000 V/m. Preferably, the electric field strength is in the range of from 0-30,000V/m.

Suitable examples of addition acids to be used include hydrochloric acid, acetic acid, sulfuric acid and nitric acid. Preferably, the addition acid is hydrochloric or nitric acid. More preferably, the addition acid is hydrochloric acid.

Suitable examples of addition bases include sodium hydroxide, sodium carbonate, sodium bicarbonate, potassium hydroxide, and potassium.

Preferably, the addition base is sodium hydroxide or potassium hydroxide. More preferably, the addition base is sodium hydroxide.

Suitable examples of salts to be used include sodium chloride, sodium iodide, sodium bromide, potassium sulphate and potassium nitrate. Preferably, the salt is sodium chloride or potassium sulphate. More preferably, the salt is potassium chloride salt.

In accordance with the present invention suitably all or substantially all of the liquid material is subjected to the external stimulus. Preferably, all of the liquid material is subjected to the external stimulus.

Preferably, in the process according to the present invention the friction coefficient between the surfaces of the first and second object decreases.

Preferably, the adjustment of the shear behaviour of the liquid material is reversible. This has the advantage that movement can be applied at will, while holding position is also possible.

Preferably, the friction coefficient between the surfaces of the first and second object is directionally dependent. This means that the object can be moved in one direction, while maintaining its orientation in another direction.

Suitable examples of first objects include a silicon housing in a MEMS, and a silicon wafer handler.

Preferably, the first object is a silicon housing.

Suitable examples of second objects include a silicon rotor and a silicon wafer.

Preferably, the second object is a silicon rotor in a MEMS (Micro Electro Mechanical System).

In a very attractive embodiment of the present invention, the first object is a silicon housing and the second object is a silicon rotor in a MEMS (Micro Electro Mechanical System).

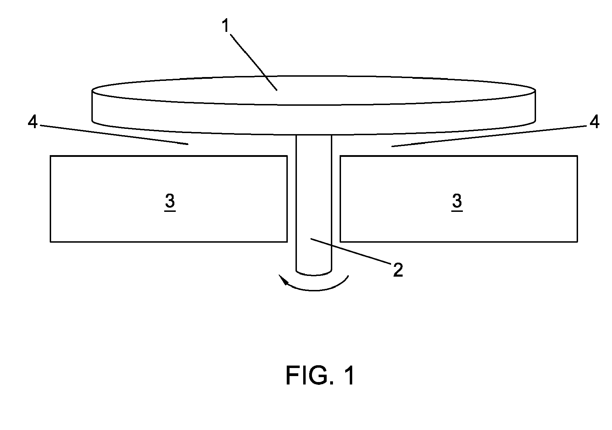

The present invention will now be illustrated by means of Figure 1-3.
Figure 1 shows a typical layout for a MEMS device: a rotor (1) is connected through a shaft (2) to a housing (3). The disc on top of the rotor (1) has a large surface, which comes close to the housing (4). Due to attractive forces between the disk and the housing, the rotor can become stuck to the housing, making movement impossible.

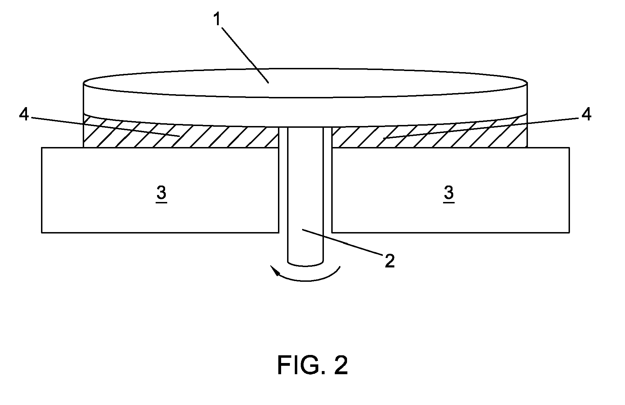

Figure 2 shows the same MEMS, but this time with a liquid (4) filling the gap between the disk and the housing. The movement of the disk on top of the housing is now determined by the shear behaviour of the liquid.

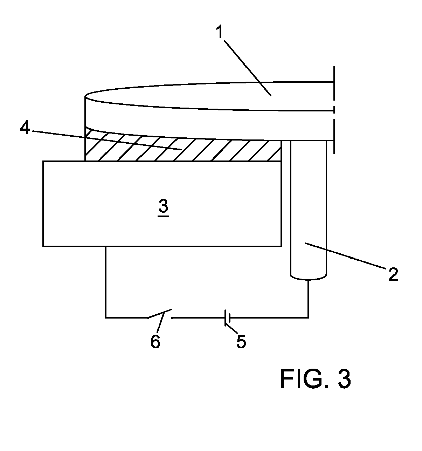

Figure 3 shows how by means of an electrical switch (6) and a direct current electricity source (5) an electrical potential can be applied over the gap between the disk and the housing (4). If the switch is closed, an electrical field will be present over the liquid in the gap. If a variable potential electricity source is used, the strength of the electrical field in the liquid (4) can be continually adjusted. By choosing an appropriate liquid (4) for which the shear properties depend on the size and/or direction of the electric field, one can thus influence the movement of the rotor (1) with respect tot the housing (3).

## Claims

1. A process for adjusting the friction coefficient between a surface of a first solid object and a surface of a second solid object which surfaces are at least partly connected by means of a liquid material, wherein the shear behaviour of the liquid material is adjusted by subjecting at least part of the liquid material to an external stimulus.

2. The process according to claim 1, wherein the external stimulus establishes a change in the concentration, the agglomeration, the conglomeration or the stacking of particles that are present in the liquid material, or said stimulus establishes a phase transition in the liquid material.

3. The process according to claim 1 or 2, wherein the liquid material is a colloid or a suspension.

4. The process according to claim 2 or 3, wherein the particles present in the liquid material are charged or magnetic particles.

5. The process according to claim 4, wherein the charged particles are clay particles.

6. The process according to claim 5, wherein the clay particles are kaolinite, smectite, illite or chlorite particles.

7. The process according to claim 4, wherein the charged particles are pigment particles.

8. The process according to claim 7, wherein the pigment particles are titanium oxide or zinc oxide particles.

9. The process according to claim 4, wherein the magnetic particles are iron or magnetite particles.

10. The process according to claim 4 or 9, wherein the magnetic particles comprise a magnetic phase and a non-magnetic phase.

11. The process according to any one of claims 3-10, wherein the liquid phase of the colloid comprises water, a mineral oil, a vegetable oil or an organic solvent.

12. The process according to any one of claims 1-11, wherein the liquid material comprises liquid crystals.

13. The process according to claim 12, wherein the liquid crystals comprise cholesterol derivates.

14. The process according to any one of claims 1-13, wherein the external stimulus is heat, pressure, electro-magnetic radiation, a magnetic field, an electric field, an addition of an acid or a base, or a salt.

15. The process according to claim 14, wherein the external stimulus is heat or a magnetic field.

16. The process according to any one of claims 1-15, wherein all or substantially all of the liquid material is subjected to the external stimulus.

17. The process according to any one of claims 1-16, wherein the friction coefficient decreases.

18. The process according to any one of claims 1-17, wherein the adjustment of the shear behaviour of the liquid material is reversible.

19. The process according to any one of claims 1-16, wherein the adjustment of the friction coefficient is directionally dependent.

20. The process according to any one of claims 1-19, wherein the first object is a silicon housing and the second object is a silicon rotor in a MEMS (Micro Electro Mechanical System).
